# EUROPEAN PATENT SPECIFICATION

(11) **EP 0 171 232 B1**
(45) Date of publication and mention of the grant of the patent: **07.04.1993**
(21) Application number: 85305271.0
(22) Date of filing: 24.07.1985
(51) Int. Cl.: H05K 3/36, H01L 23/48, H01L 23/14

(54) **Area-bonding tape**
Band für die Anschweissung von Flächen
Ruban pour la soudure de surfaces

(30) Priority: 09.08.1984 US 639493
(43) Date of publication of application: 12.02.1986
(73) Proprietor: MINNESOTA MINING AND MANUFACTURING COMPANY, St. Paul, Minnesota 55133-3427 (US)
(72) Inventor: Rohloff, Robert R. c/o Minnesota Mining and, St. Paul Minnesota 55133 (US)
(74) Representative: Baillie, Iain Cameron

(56) References cited:
- EP-A- 0 072 673
- EP-A- 0 083 265
- EP-A- 0 148 083
- US-A- 4 048 438

## Description

### Technical Field

This invention is directed to a flexible area-bonding tape for providing electrical interconnection between electronic components and external circuitry according to the prior art part of claim 1. The tape is particularly useful in electrically connecting small electronic components, such as semiconductor chips, to external circuitry, such as ceramic packages.

### Background Art

Small electronic components, such as semi-conductor chips or devices, typically have bonding locations for electrical connection to external circuitry either on the periphery of a single face or in an array spread over a large portion of a single face. The other face of such devices is typically used as an electrical ground connection. Devices employing peripheral bonding locations provide a very limited number of access points for electrical connection due to the small area available for such points.

Devices employing an array of contact points spread over the face of the device (also known as "flip chip" devices) overcome this disadvantage by increasing the area available for such points. Flip chip devices are commonly electrically interconnected to external circuitry by aligning their array of bonding locations, such as metallized bumps or protrusions above the surface of the device, with corresponding bonding locations on the external circuitry and forming a metallurgical bond between the two sets of bonding locations by, for example, reflow soldering, thermocompression bonding, ultrasonic bonding, or thermosonic bonding.

There are at least two serious drawbacks to these interconnection techniques. First, there is a large difference in the coefficients of thermal expansion (TCE) of electronic components such as semiconductor devices typically made from silicon (e.g., TCE of 2.8 x 10⁻⁶ units/unit), and external circuitry such as ceramic packages typically made from alumina (e.g., TCE of 6.8 x 10⁻⁶ units/unit). This difference causes physical stresses on the metallurgical bond between the bonding locations during the thermal cycling encountered during testing and use of the assembled part. The stress must be limited if failure of the metallurgical bond is to be avoided. Commonly the thermal cycling range to be encountered by the assembled part is specified and cannot be limited to less than that specified. Consequently, limiting the stress must be accomplished by limiting the physical magnitude of the stress, typically by limiting the maximum difference in distance between any bonding locations in the array. This limits the size of the array and, consequently, the placement of the bonding locations on the device.

Second, it is normally necessary to remove heat generated during electrical functioning of the semi-conductor device. The most effective means of removal is by conducting the heat from the device to the substrate. This is best accomplished by maximizing the contact between the semiconductor device and the ceramic package. This is typically done by bonding the backside of the device down to the package. However, in the case of flip chip devices, the contact area to the package is limited to the area of the metallurgical bonds. This can be as small as 5% of the area of the device and can severely impair removal of heat from the device to the substrate.

The present invention overcomes these disadvantages. It provides a compliant or flexible article which can absorb the stress caused by thermal expansion mismatch. Additionally, the present invention makes it possible to locate the bonding anywhere on the face of the semiconductor so that it is no longer necessary that the electrical connection points be limited to peripheral arrays of limited size. As a result, more electrical connection points may be provided on a semiconductor device.

The present invention also permits one surface of the device (such as the side not bonded to the tape of the present invention) to be placed in maximum area contact with the substrate providing maximum thermal conduction while the bonding locations on the other surface of the device can be placed in thermal contact with the tape, thereby permitting additional thermal transfer.

Still further the present invention permits direct electrical contact to the back of the device if desired. This is particularly useful when it is desired to electrically ground the device.

The present invention provides still other advantages. Thus, when applied to electronic components and the external circuitry it protects the assembled devices active surfaces from alpha particles which would otherwise impinge upon the electronic components and undesirably change their electrical state.

Additionally, the open terminals of the present invention permit visual alignment of the bonding protrusions and terminals prior to bonding and also visual inspection of the bonded article after bonding has been completed.

Still further, laser bonding techniques may be used using this invention because the open terminals permit direct access of laser radiation to the solder bump for reflowing purposes.

The present invention also provides stronger bonds by providing more surface area and an additional mechanical bond due to solder flow into the open terminal.

Still further, the present invention makes it possible to achieve higher terminal array density due to the ability to more precisely form the terminals.

Several devices have been previously suggested for interconnecting electronic components to external circuitry. However, these devices have either been intended for use in electrically interconnecting devices which employ peripheral contact points, or they lack one or more of the essential elements of the present invention.

For example, U.S. Patents 3,832,769 and 3,868,724 disclose structures wherein a pattern of electrical contacts on one surface are electrically interconnected to a pattern of electrical contacts on another surface. These structures employ solid conductive posts through a single layer of a dielectric material to join the two patterns of electrical contacts and provide only limited space for electrical contact points.

U.S. Patent 4,064,552 describes a tape bearing a foil pattern thereon which has individual electrical terminals to receive components. The foil pattern is on a dielectric carrier and has interlayered connections through apertures filled with electrically conductive material in the carrier. The dielectric layers of the tape are adhesively secured to one another.

U.S. Patent 3,780,352 discloses the use of a set of thin metallic film strips bonded to a thin flexible dielectric support. The metal strips electrically interconnect contact pads on semiconductor chips to selected leads.

U.S. Patent 4,251,852 discloses a wiring skirt for electrically interconnecting two identical semiconductor chips to a common set of contacts. The wiring skirt is built in-situ around the semiconductor chips.

United States Application Serial No. 292,401 discloses a tape comprising a flexible, electrically insulating body having arrays of solid, electrically conductive internal and external electrical terminals which are electrically interconnected by multiplicities of conductive paths.

All of these patents and applications employ solid, electrically conductive terminals. Such terminals do not permit visual alignment and inspection of the bonding protrusions and the terminals either prior to or subsequent to bonding. Furthermore, they do not provide bonds as strong as those achieved by the use of the present invention. Moreover, the devices of U.S. Patent Nos. 3,832,769; 3,868,724; 4,064,552; 3,780,352; and 4,251,852 make it difficult to achieve high terminal density. A flexible area-bonding tape according to the prior art part of claim 1 is known from 0 072 673. EP-A-0 083 265 discloses a flexible area-bonding tape comprising metallized through holes in external terminals.

### Disclosure of the Invention

According to this invention there is provided a flexible area bonding-tape as claimed in claim 1.

The present invention provides a flexible tape for providing electrical interconnection between electronic components and external circuitry. The tape comprises a solid, flexible, electrically insulating body having a predetermined array of open internal and external terminals for electrically interconnecting electrical components to external circuitry. The internal and external terminals are electrically interconnected to each other by a multiplicity of conductive paths, preferably provided in more than one layer. At least some of these paths are preferably at least partially embedded or buried within the body of the tape. Thus, this embodiment of the invention is comprised of multiple, alternate layers of an electrical conductor, and an insulating body.

The electrically conductive paths are comprised of discrete electrically conductive traces of a desired geometry which interconnect individual internal terminals to the desired external terminals. The material of the insulating body separates the various conductive traces and permits the traces to be routed in a number of ways so as to provide the maximum latitude in the design of the various arrays of terminals. The terminals comprise openings or vias which pass entirely through the tape. At least a portion of the side-walls of the vias comprises electrically conductive material so as to provide a conductive path between the first and second major surfaces of the tape. Preferably the traces surround the vias on the major surface of the tape so as to provide land areas on the major surfaces.

### Brief Description of the Drawings

The invention will be described in more detail hereinafter with reference to the accompanying drawings wherein like reference characters refer to the same parts throughout the several views and in which:
FIGURE 1 is a cross-section view showing one embodiment of the tape of the invention interconnecting an electronic component, here a semiconductor chip, to external circuitry, here a ceramic package;
FIGURES 2-3, respectively, show the bottom and top surfaces of the tape of the invention.
FIGURES 4-10 show sequential steps in one method for the manufacture of the tape of the invention;
FIGURE 11 is an enlarged view of the tape of the invention bonded to a semiconductor chip.
FIGURE 12 is an alternative embodiment of the tape of the invention.

### Detailed Description

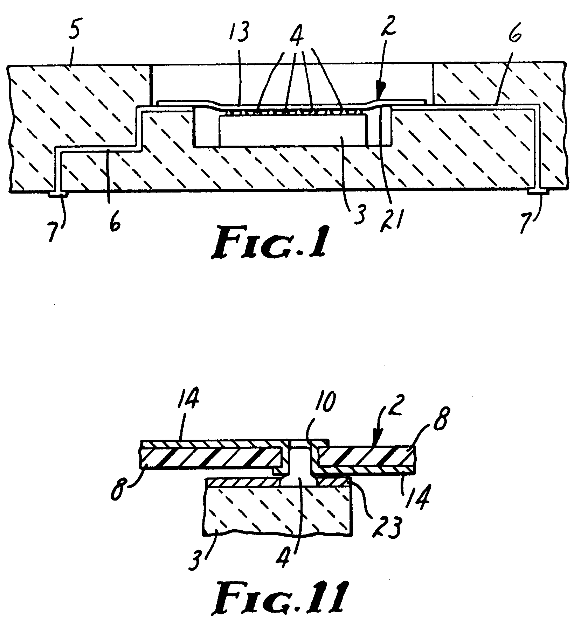

FIGURE 1 shows a cross-section view of tape 2 interconnecting an array of bonding locations 4 (here bumps) of a semiconductor chip 3 (the electronic component) to conductive paths 6 of ceramic package 5 (the external circuitry). As shown in FIGURE 1, conductive paths 6 of package 5 terminate in outer bonding locations 7. Tape 2 has top surface 13 and bottom surface 21.

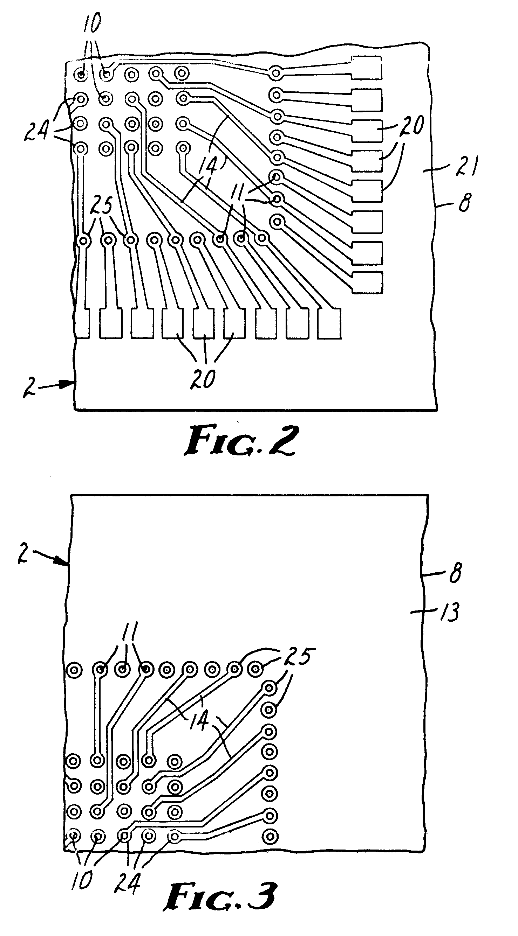

FIGURES 2-3 show details of the tape 2. FIGURE 2 shows that bottom surface 21 of tape 2, that is the surface which is bonded to bonding locations 4 and conductive paths 6, comprises a dielectric material 8, an array of internal terminals 10, and an array of external terminals 11. FIGURE 2 also shows an optional array of test terminals 20. Internal terminals 10, external terminals 11, and test terminals 20 are electrically interconnected by means of conductive paths 14 as is shown in FIGURE 2.

FIGURE 3 shows the top 13 of tape 2. This view is similar to that of FIGURE 2 except that it shows the electrical interconnection of those internal, external and optional test terminals not shown as being interconnected in FIGURE 2. Thus, FIGURE 3 shows that top surface 13 comprises a dielectric material 8, an array of internal terminals 10 and an array of external terminals 11. Conductive paths 14 interconnect the various terminals. In these FIGURES, the conductive paths 14 surround the internal terminals at 24 and the external terminals at 25.

As shown in these FIGURES, conductive paths 14 are at least partially electrically isolated from one another and are situated on the surfaces of the tape 2. It is possible, however, for at least some of the conductive traces 14 to be embedded or buried within the body of the tape 2.

FIGURES 2 and 3 show patterns of conductive paths 14 as they might exist on surfaces 13 and 21 of tape 2. They also show a given array pattern for each of the internal and external terminals. FIGURE 2 further shows an array pattern for test terminals 20. The pattern of these arrays and the geometric configuration of the conductive paths are selected so as to achieve a desired configuration of the terminals. The exact pattern and configuration selected is not critical to the invention, and is chosen so as to satisfy the requirements for interconnection to the electronic component and the external circuitry and avoid any undesired electrical interconnections that would result in short-circuiting, or capacitance or impedance effects. Within these parameters, a wide variety of designs and configurations may be utilized.

The insulating material of tape 2 is flexible and is preferably in the range of 2.5-250 micrometers thick. Useful insulating materials include thin, flexible films of polyimide, polyester, acrylic, fluorocarbon films such as Teflon™, polysulfone, polyamide, poly(imide-amide), silicone, and glass fiber reinforced thermoset plastics. Most preferably these insulating materials are resistant to high temperatures.

The various conductive elements of the tape are preferably fabricated from metals such as aluminum, copper, nickel, silver, gold, tin and the like. Alloys of these metals either with each other or with other metals are also useful. Terminal walls plated with bimetallic materials, for example solder plated copper, tin plated copper or gold plated nickel, are also useful. The thickness of the various conductive elements must be at least sufficient to allow electrical conductivity and they may be as thick as 125 micrometers, although thinner terminal walls and paths, such as 10 to 15 micrometers, are generally preferred for reasons of economics.

The open terminals or vias of tape 2 may have any circumferential shape and dimension desired. Thus, for example, they may be circular, rectangular, triangular, etc. Generally the vias in a given array are all of the same circumferential shape and dimension although they need not be so. Thus, for example, circular terminals may have diameters of from 25 to 500 micrometers. Terminals of other shapes will commonly have open areas corresponding to those of the circular terminals.

The pattern of the various arrays of terminals may also be varied. Thus, the array of internal terminals 10 may comprise a multiplicity of horizontal and vertical rows as is shown in FIGURES 2-3. These arrays are, of course, merely descriptive and may be varied to suit the pattern of the bonding locations of the electronic component to which the tape is to be attached.

The array of external terminals 11 is typically peripherally situated about the array of internal terminals 10. It may comprise a single row of terminals which surrounds the array of internal terminals 10 as is shown in FIGURES 2-3, or it may comprise other geometric patterns. The exact pattern of the array may be varied to meet the pattern of the bonding locations of the external circuitry to which it is to be attached. It is not necessary that the array of external terminals 11 totally surround the array of internal terminals 10.

The array of test terminals 20 may also vary in its pattern. Thus, while the FIGURES show the array as a row of land areas which surrounds the array of external terminals 11, other patterns may be utilized if desired. Additionally, terminals 20 may also be open as are terminals 10 and 11.

In use, tape 2 is applied to an electronic component such as a semiconductor chip 3 so that the array of internal terminals 10 is disposed to be in registry with bonding locations 4 (i.e., the bumps). The tape 2 is then bonded to chip 3. During bonding the bumps soften and flow into the terminals. The resultant bond is shown more clearly in FIGURE 11.

As can be seen by reference to FIGURE 11, tape 2 comprises a dielectric substrate 8 having electrically conductive traces 14 which surround open terminal 10 and provide a conductive path from the top to the bottom of tape 2. Tape 2 is bonded to an electronic component (here semiconductor chip 3). Chip 3 has bonding location (or bump) 4 joined to conductive path 23.

During the bonding operation, bump 4 has been softened and caused to flow into open terminal 10. This provides more surface area contact between the terminal and the bump, giving increased mechanical contact and resulting in a stronger bond.

After bonding, the chip 3 may be functionally tested by probing test terminals 20 with electronic test equipment. If either chip 3 or any of the interconnecting bonds is faulty, the assembly may be discarded or repaired before committing it to even more expensive assembly operations. If the chip 3 and the interconnecting bonds are good, test terminals 20, if present, may be removed. The array of external terminals 11 is then disposed to be in registered contact with the external circuitry to which the semiconductor chip 3 is to be attached and the tape 2 is bonded to the bonding locations on package 5. Tape 2 may then be bonded to semiconductor chip 3 and the external circuitry by, for example, reflow soldering, thermo-compression techniques, ultrasonic techniques, or thermosonic techniques to form a metallurgical bond between internal and external contacts 10 and 11 and the appropriate bonding locations. The resulting assembled device is then ready for use.

The tape 2 may be prepared by a number of techniques. The following procedure represents one of such techniques. Reference to FIGURES 4 - 10 will aid in understanding this procedure. FIGURE 4 shows a film of dielectric material 8. This film is thin (e.g., 2.5 to 250 micrometers) and preferably comprises a material such as Kapton® film. Kapton® film is commercially available from E. I. duPont de Nemours and Company. The film of dielectric material 8 may have a plurality of sprocket holes (not shown) along its longitudinal edges to aid in both its manufacture and subsequent processing.

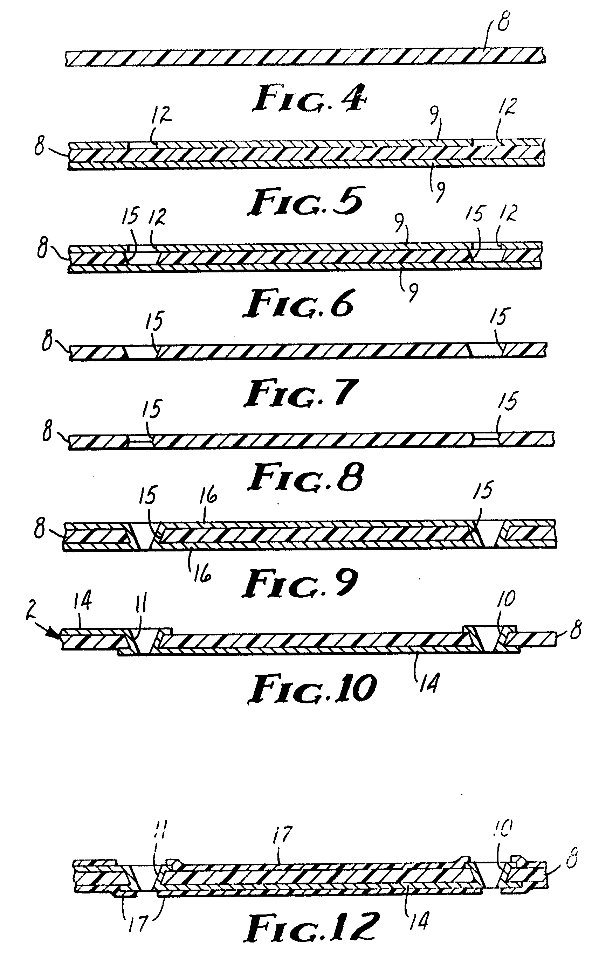

A layer of photoresist 9 is applied to both layers of the film and the photoresist is exposed in an image-wise manner to activating radiation and developed so as to provide holes 12 in photoresist 9. Such techniques are well known in the art. See FIGURE 5.

Standard photolithographic techniques may then be used to image one side of the dielectric material 8 through the openings or holes 12 in the photoresist 9. The exposed dielectric material 8 is then removed by, for example, known wet or dry removal techniques such as chemical milling (see U.S. Patent 3,395,057), laser and electron beam drilling, abrasive techniques, mechanical drilling, plasma etching, or reactive ion milling to provide holes 15. See FIGURE 6.

The photoresist 9 may then be removed to provide a dielectric material 8 having the desired arrays of openings 15 therein as is shown in FIGURE 7. The resulting holes 15 provide openings or vias through dielectric material 8.

The techniques employed to provide holes 12 and 15 can be done from both sides of the dielectric material 8. This makes it possible to form holes 15 having the same, or nearly the same, diameter mouth on both surfaces of the dielectric material. See FIGURE 8. This result is particularly useful where very close spacing of the vias are desired.

Whether single or double-sided techniques are used to generate holes 15, a thin layer of an electrically conductive material 16 (such as copper) is deposited on the dielectric material 8 using known techniques such as electroless plating, electron beam deposition, thermal evaporation, or sputter deposition. See FIGURE 9. The layer of conductive material 16 is applied over the entirety of the major surfaces of dielectric material 8 and on the sides of holes 15. Typically this layer is in the range of 0.01 to 0.1 micrometers thick although it may be thinner or thicker. The thickness of this layer is then increased to from 5 to 10 micrometers using known techniques such as electroplating.

A fresh layer of photoresist (not shown) is reapplied over the layer of conductive material 16 and image-wise exposed so as to create a differential pattern thereon which ultimately will correspond to the desired pattern of conductive paths 14. After exposure, the photoresist is developed, the exposed copper is etched to remove unwanted copper and provide the desired patterns of conductive paths 14 and the conductive sidewalls of the open vias. The remaining photoresist is then removed. FIGURE 10 represents a cross-sectional view of a portion of the resulting structure. It shows dielectric material 8, internal terminals 10, external terminals 11 and conductive traces 14.

Although the FIGURES show a tape having a single layer of dielectric material, the invention is not limited to this embodiment. Thus, the invention may also comprise a tape wherein at least some of the conductive paths 14 are essentially completely buried or embedded within the tape. This may be accomplished by applying a layer of an indirectly imageable material over major surfaces and via walls of the structure of FIGURE 10. Such a layer may be applied from a solution of the material followed by removal of the solvent. Preferably, the material has high heat resistance. Polyamic acid (e.g., Pyre ML from E. I. duPont de Nemours and Company), is one useful material for this purpose.

A photoresist is then applied over the layer of indirectly imageable material, exposed to activating radiation in an image-wise manner so as to provide areas which will ultimately provide access to the indirectly imageable material, and developed so as to remove the photoresist from the exposed areas. The exposed indirectly imageable coating is then removed, e.g., by chemically etching it with a basic solution. The remaining photoresist is then removed and indirectly imageable material is then cured or crosslinked. The conversion of polyamic acid in this fashion is shown in U.S. Patent 4,242,437.

FIGURE 12 shows the resulting structure. It is the same as that of FIGURE 10 except the layer of indirectly imageable material 17 has been added to the structure.

In the tape of the invention the internal and external terminals comprise the holes or vias through the tape 2. As can be seen, at least a portion of these holes have electrically conductive material as a part of their side walls. However, it is not necessary that the entire side walls he plated with conductive material. It is only necessary that the bonding protrustions on, for example, the electronic component be able to reach into the holes making electrical contact with the electrically conductive portion of the terminal.

## Claims

1. A flexible area-bonding tape (2) for providing electrical interconnection between electronic components and external circuitry, said tape (2) comprising a flexible, solid, electrically insulating body having a predetermined array of internal terminals (10) situated across the face of the tape for interconnection to said electronic component, a predetermined array of external terminals (11) around said internal terminals on the face of the tape for electrical interconnection to said external circuitry, said internal and external terminals (10 and 11) being electrically interconnected by conductive paths (14) provided in more than one level and being electrically isolated from one another, at least some of said conductive paths being routed throughout said body so as to essentially completely embed at least some of said paths along horizontal paths, characterized in that each of said internal and external terminals (10,11) comprise an opening which passes through said tape between first and second major surfaces for registry with and direct electrical connection to said electrical component and said external circuitry, wherein at least a portion of only the sidewalls of the openings comprises an electrically conductive material so as to provide a conductive path between said first and second major surfaces.

2. A tape (2) according to claim 1 wherein said insulating material is a polymer.

3. A tape (2) according to claim 1 wherein said polymer is a polyimide.

4. A tape (2) according to claim 1 wherein the entire walls of said openings are electrically conductive.

## Patentansprüche

1. Ein flexibles Flächenverbindungsband (2) zur elektrischen Verbindung zwischen elektronischen Bauelementen und einer externen Schaltung, wobei das Band (2) aus einem flexiblen, starken, elektrisch isolierenden Körper besteht, der ein vorbestimmtes Netz von inneren Anschlußklemmen (10) aufweist, die durch die Bandseite angeordnet sind, zur Verbindung mit dem elektronischen Bauelement, mit einem um die inneren Anschlußklemmen angeordneten vorbestimmten Bereich mit äußeren Anschlußklemmen (11) auf der Bandseite zur Verbindung mit der externen Schaltung, wobei die inneren und äußeren Anschlußklemmen (10 und 11) durch Leiterbahnen (14), die auf mehr als einer Ebene angeordnet und voneinander elektrisch isoliert sind, elektrisch verbunden sind, wobei mindestens einige dieser Leiterbahnen durchgehend durch den Körper geführt werden, um so zumindest einige dieser Leiterbahnen praktisch völlig entlang horizontaler Bahnen einzubetten, dadurch gekennzeichnet, daß jede der internen und äußeren Anschlußklemmen (10,11) eine Öffnung aufweist, die sich zwischen der ersten und der zweiten Hauptbandseite durch das Band erstreckt, zur Ausrichtung nach und zur direkten elektrischen Verbindung mit dem elektronischen Bauelement und der externen Schaltung, wobei zumindest nur ein Teil der seitenwändeöffnungen ein elektrisch leitendes Material aufweist, sodaß eine Leiterbahn zwischen der ersten und der zweiten Hauptbandseite hergestellt wird.

2. Ein Band (2) gemäß Anspruch 1, wobei das isolierende Material ein Polymer ist.

3. Ein Band (2) gemäß Anspruch 1, wobei das Polymer ein Polyimid ist.

4. Ein Band (2) gemäß Anspruch 1, wobei die gesamten Wände der Öffnungen elektrisch leitend sind.

## Revendications

1. Ruban flexible (2) de liaison par zones destiné à établir une interconnexion électrique entre des composants électroniques et des circuits extérieurs, ledit ruban (2) comportant un corps électriquement isolant, solide, flexible, ayant un réseau prédéterminé de bornes intérieures (10) situées sur la face du ruban pour une interconnexion avec ledit composant électronique, un réseau prédéterminé de bornes extérieures (11) autour desdites bornes intérieures sur la face du ruban pour une interconnexion électrique avec lesdits circuits extérieurs, lesdites bornes intérieures et extérieures (10 et 11) étant interconnectées électriquement par des pistes conductrices (14) prévues dans plus d'un niveau et étant isolées électriquement les unes des autres, au moins certaines desdites pistes conductrices étant acheminées à travers ledit corps afin qu'au moins certaines desdites pistes soient noyées essentiellement complètement suivant des trajets horizontaux, caractérisé en ce chacune desdites bornes intérieures et extérieures (10, 11) comprend une ouverture qui passe à travers ledit ruban entre des première et seconde surfaces principales pour être en alignement et en connexion électrique directe avec ledit composant électrique et lesdits circuits extérieurs, au moins une partie uniquement des parois latérales des ouvertures comprenant une matière électriquement conductrice de façon à établir un trajet conducteur entre lesdites première et seconde surfaces principales.

2. Ruban (2) selon la revendication 1, dans lequel ladite matière isolante est un polymère.

3. Ruban (2) selon la revendication 1, dans lequel ledit polymère est un polyimide.

4. Ruban (2) selon la revendication 1, dans lequel les parois entières desdites ouvertures sont électriquement conductrices.
